# FASCICULE DE BREVET EUROPEEN

(11) **EP 2 984 454 B1**
(45) Date de publication et mention de la délivrance du brevet: **06.06.2018**
(21) Numéro de dépôt: 14720664.3
(22) Date de dépôt: 07.04.2014
(51) Int. Cl.: G01D 5/14, G01R 33/00, G01D 4/00

(54) **DISPOSITIF DE SIMULATION DE MOUVEMENT**
VORRICHTUNG ZUR SIMULATION EINER BEWEGUNG
DEVICE FOR SIMULATING MOVEMENT

(30) Priorité: 12.04.2013 FR 1353329
(43) Date de publication de la demande: 17.02.2016
(73) Titulaire: Diehl Metering S.A.S., 68300 Saint-Louis (FR)
(72) Inventeur: BACH, Guy, F-68640 Waldighoffen (FR); DOCKWILLER, Bernard, F-68720 Saint-Bernard (FR)
(74) Mandataire: Kress, Jean-Jacques Gilbert
(86) Numéro de dépôt international: PCT/FR2014/050826
(87) Numéro de publication internationale: WO 2014/167232

(56) Documents cités:
- EP-A1- 2 163 905
- FR-A1- 2 882 818
- US-A1- 2003 094 916

## Description

### DOMAINE TECHNIQUE DE L'INVENTION

Le domaine technique de l'invention concerne les dispositifs permettant de compter le nombre de rotation d'une cible. L'invention se rapporte plus particulièrement à un dispositif qui simule un mouvement de rotation.

### ÉTAT DE LA TECHNIQUE ANTERIEURE

Il est généralement connu des dispositifs de traitement d'informations numériques issues de la traduction d'une donnée ou grandeur analogique mesurée. Ces dispositifs de traitement sont souvent spécifiques au domaine dans lesquels ils sont utilisés.

Par exemple, dans le milieu du comptage d'eau il est courant de vouloir équiper un compteur d'eau avec un module radio compact. Afin de réduire le nombre d'appareils il convient de définir un principe de modularité qui impose à tous les compteurs et à tous les modules radio compacts l'emploi d'un même système d'interfaçage. Il est alors possible de panacher toute la gamme de compteurs d'eau avec toute la gamme de modules radio compacts. Mais dans le cas d'un compteur non modulaire (compteur d'eau d'un concurrent, autre type de compteur, ancien modèle...) que l'on veut tout de même équiper d'un module radio il est courant de devoir réaliser un module radio déporté spécifique et de le relier par un câble à un capteur qui est monté sur le compteur. Le développement d'un tel module radio déporté spécifique est cher et peu rentable car les volumes de vente sont souvent très faibles. Il se pourrait même qu'il faille développer plusieurs modules radio déportés si toutes les fonctionnalités ne peuvent être intégrées dans un seul (exemple : plusieurs fréquences radio très différentes).

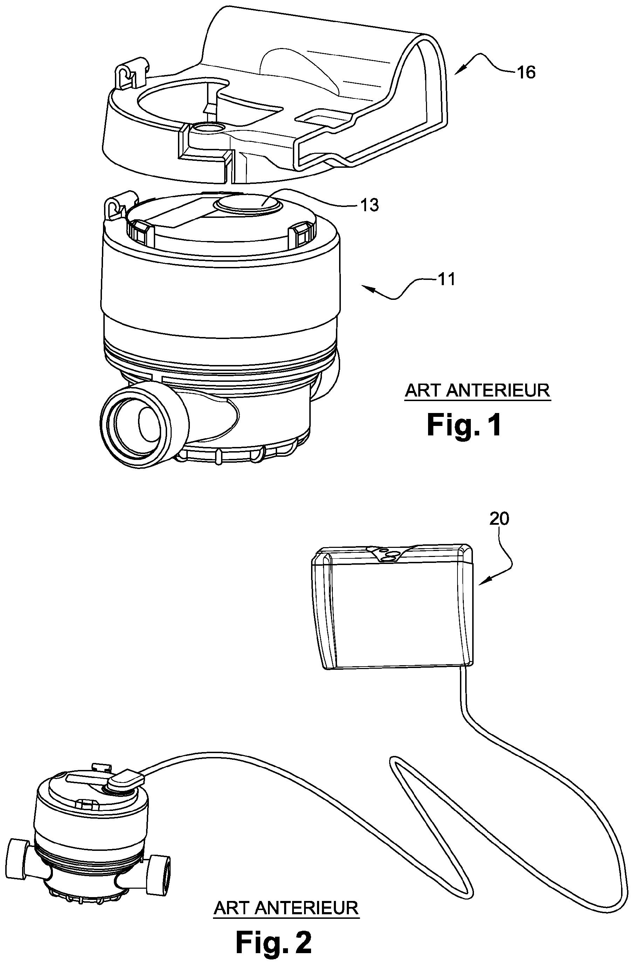

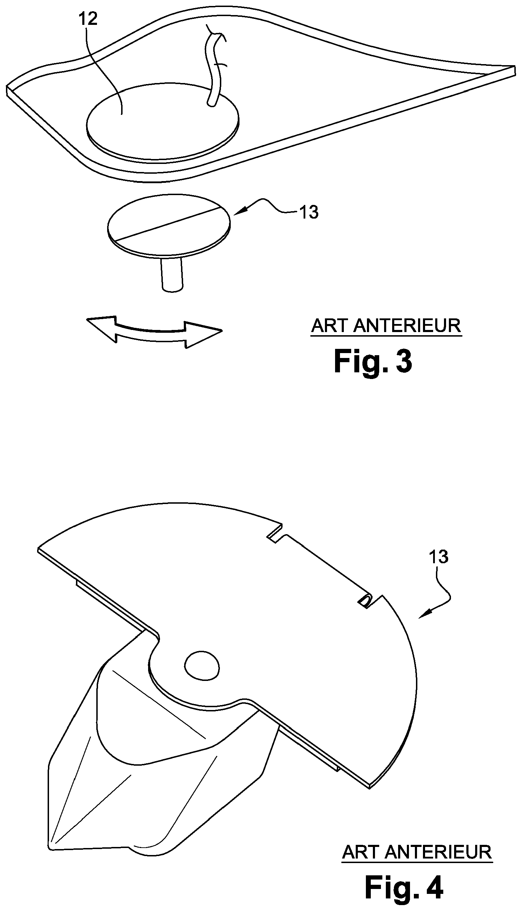

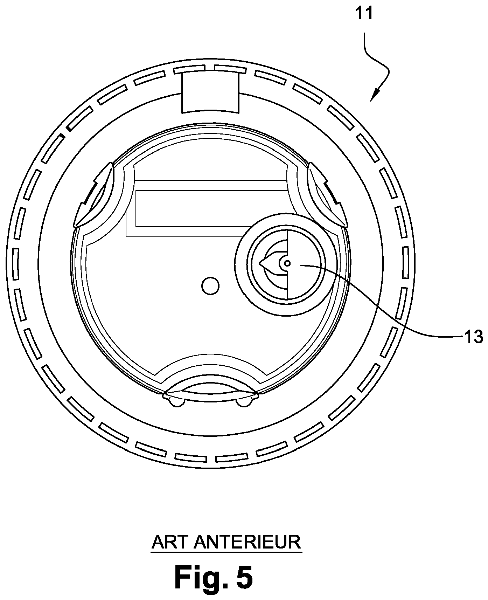

Ainsi, en référence aux figures FIG. 1, FIG. 2, FIG. 3, FIG. 4 et FIG. 5, est connue dans le domaine des compteurs d'eau l'utilisation d'un demi-disque (13) métallisé fixé sur un axe de rotation actionné par une turbine de compteur d'eau (11) ou d'un quelconque fluide. Le demi-disque (13) grâce à sa rotation, entraîné par la turbine, va permettre ainsi de traduire numériquement le débit de l'eau. En regard du demi-disque (13) est disposé un capteur inductif (12) ayant pour fonction de détecter les tours effectués par le demi-disque (13). Le capteur inductif (12) est relié à un dispositif de traitement des informations, par exemple un module radio déporté (20) ou un module radio compact (16) clipsé sur le compteur, programmé pour interpréter les dites informations venant du capteur inductif (12). Peuvent alors être mis à disposition des données numériques, comme par exemple le débit d'eau traversant le compteur, ou encore le nombre de litres d'eau écoulés depuis un temps donné. Ce dispositif de traitement des informations est souvent spécifique aux types d'informations reçues et / ou à un type donné de compteur (différents compteurs pour chaque constructeur).

Il en va de même pour un grand nombre de domaines autres que le comptage de l'eau, par exemple le domaine du comptage en général, et plus généralement encore dans tous les domaines impliquant le traitement d'une information numérique collectée à partir d'une donnée ou d'une grandeur analogique mesurée.

Cette spécialisation des différents dispositifs de traitement des informations à chaque domaine d'utilisation, chaque appareil et chaque type d'information est coûteuse et parfois peu rentable du fait de faibles volumes de vente, à l'inverse d'un dispositif générique qui serait donc compatible avec les appareillages préexistants aussi bien que les nouveaux appareillages.

EP 2 163 905 Al divulgue un dispositif de simulation de mouvement similaire.

### EXPOSE DE L'INVENTION

La présente invention vise notamment à résoudre tout ou partie des inconvénients de l'état de la technique en proposant notamment un dispositif de simulation du mouvement. Le dit dispositif est plus simple en ce qu'il peut équiper tous les appareillages servant à transformer une donnée ou une grandeur analogique en donnée numérique, et en ce qu'il est paramétrable facilement en fonction de l'appareillage auquel il est associé. Il est aussi plus pratique en ce qu'il peut équiper tant des appareillages neufs que préexistants. Enfin, du fait que ses composants sont peu coûteux et qu'il s'agit d'un dispositif générique pour tous les dits appareillages, des économies d'échelle pourront être réalisées.

À cet effet l'invention propose un dispositif de simulation remarquable en ce qu'il comprend un capteur de rotation et une surface disposée en vis-à-vis du capteur de rotation, la surface comprenant des moyens de simulation d'un mouvement comprenant au moins deux bobines fixes par rapport au capteur, dispositif caractérisé en ce que :
- le capteur de rotation est composé de bobines plates et comprend une bobine d'excitation électromagnétique,
- chaque bobine de la surface est reliée à une première sortie d'une électronique de contrôle,
- l'impédance d'au moins une bobine de la surface varie sensiblement différemment de l'impédance de l'autre ou des autres bobine(s), et
- l'électronique de contrôle comprend des moyens de contrôle de l'impédance des bobines sous la forme de moyens de mise en court-circuit. Ainsi il est possible de simuler le demi-disque réel avec un circuit électronique statique. La face du premier capteur en regard des bobines peut être considérée comme étant la deuxième surface.

Les bobines peuvent être reliées à la première sortie électriquement au moyen d'une connexion électrique.

Le capteur est disposé en regard des bobines de manière à pouvoir rendre possible une induction mutuelle avec les bobines.

Les avantages de l'exploitation de l'induction mutuelle résident notamment dans la robustesse et l'économie d'énergie.

Avantageusement, les bobines sont des composants robustes qui n'ont pas de limite en durée de vie, la durabilité du dispositif s'en trouve améliorée.

Avantageusement, et afin de permettre l'induction mutuelle, il est possible de n'alimenter que le capteur en énergie. Il est aussi possible de n'alimenter que les bobines pour le même effet. Une économie d'énergie supplémentaire peut donc être réalisée du fait qu'il n'est pas nécessaire d'alimenter ensemble le capteur et les bobines en énergie, mais seulement l'un des deux.

L'électronique de contrôle est alimentée en énergie.

Les moyens de contrôle de l'impédance des bobines sont des moyens de mise en court-circuit des bobines.

Les impédances des bobines prennent sensiblement deux valeurs : une valeur de court-circuit (minimale) quand les bobines sont en court-circuit, et une valeur de circuit ouvert (maximale) quand les bobines sont en circuit ouvert.

Avantageusement, les valeurs de court-circuit et de circuit ouvert étant respectivement minimale et maximal, l'amplitude de variation du signal est donc maximale et améliore notablement la qualité de détection du premier capteur.

Selon une caractéristique particulière du dispositif selon l'invention, une entrée de l'électronique de contrôle est connectée à une deuxième sortie émettant un signal électrique.

Préférentiellement, l'électronique de contrôle comprend un microprocesseur et est programmable de manière à pouvoir traduire les signaux électriques émis par la deuxième sortie en mouvements simulés d'une portion de la première surface en faisant varier l'impédance des bobines.

Avantageusement, l'électronique de contrôle peut contenir plusieurs programmes de sorte que, lorsqu'elle est reliée à la deuxième sortie, elle puisse sélectionner le programme adéquat en fonction du signal émis par la deuxième sortie pour interpréter le dit signal.

Avantageusement, la deuxième sortie est une sortie numérique.

L'électronique de contrôle peut donc par exemple contenir un programme d'interprétation des signaux reçus d'un compteur d'eau, lorsqu'elle est reliée à la deuxième sortie d'un compteur d'eau, elle sélectionne automatiquement le programme d'interprétation des signaux reçus du compteur d'eau pour pouvoir les interpréter et opérer en conséquence sur les moyens de contrôle de l'impédance des bobines.

Selon une caractéristique particulière du dispositif selon l'invention, l'ensemble comprenant les bobines et l'électronique de contrôle peut être intégré dans un module interface. Ainsi, il est possible de réaliser une embase entièrement statique qui interprète des signaux d'appareils tiers pour les transmettre aux appareils standards au travers du capteur inductif qui s'y trouve. Les appareils peuvent être clipsés sur cette embase comme s'ils étaient clipsés sur le compteur.

Selon une caractéristique particulière du dispositif selon l'invention, les bobines sont sensiblement plates ce qui permet une réduction de l'encombrement général du dispositif de simulation du mouvement ainsi que du coût du dit dispositif.

Selon une caractéristique particulière du dispositif selon l'invention, chaque bobine présente une forme en secteur de disque. Toutefois, les bobines peuvent prendre n'importe quelle forme comme par exemple une forme de disque, une forme de carré, ou une forme irrégulière.

Préférentiellement, les bobines du dispositif ont toutes la même aire.

Préférentiellement, l'ensemble des bobines du dispositif, quand elles ont une forme de secteur de disque, forme un disque complet.

L'invention concerne également un ensemble comprenant le dispositif avec une des caractéristiques précédentes et le capteur de rotation, tel que le capteur est sensible à l'induction électrique et est disposé en regard des bobines.

Selon une caractéristique particulière, le capteur et le dispositif de simulation de mouvement communiquent entre eux par une communication numérique. La communication entre le capteur et le dispositif de simulation est par exemple binaire.

Selon une caractéristique particulière de l'ensemble selon l'invention, le capteur est relié à un dispositif de traitement et d'interprétation des informations transmises par le capteur.

Le dispositif de traitement et d'interprétation comprend un microprocesseur et est programmable de manière à pouvoir interpréter les signaux reçus par le premier capteur.

L'invention concerne aussi un compteur équipé du dispositif de simulation du mouvement.

Le compteur peut être un compteur d'eau, mais aussi de gaz, ou d'électricité, cette liste est non exhaustive.

### BREVE DESCRIPTION DES FIGURES

D'autres caractéristiques et avantages de l'invention ressortiront à la lecture de la description qui suit, en référence aux figures annexées à titre d'exemple non limitatif, qui illustrent :
- la figure 1, une vue en perspective d'un compteur d'eau équipé d'un dispositif de mesure divulgué dans l'état de la technique ;
- la figure 2, une vue en perspective d'un compteur d'eau équipé d'un dispositif de mesure divulgué dans l'état de la technique ;
- la figure 3, une vue schématique en perspective de la disposition du capteur et du demi disque métallisé du compteur d'eau, divulgué dans l'état de la technique ;
- la figure 4, une vue en perspective du demi-disque métallisé divulgué dans l'état de la technique ;
- la figure 5, une vue de dessus du compteur d'eau en position verticale par rapport sol divulgué dans l'état de la technique ;
- la figure 6, une vue schématique d'une partie du dispositif de simulation du mouvement selon un mode de réalisation préféré ;
- la figure 7, une vue en perspective du module interface et du module radio compact clipsable selon un mode de réalisation préféré ;
- la figure 8, une vue du premier capteur selon un mode de réalisation préféré ;
- la figure 9, un schéma du circuit électrique formé par l'électronique de contrôle et les bobines selon un mode de réalisation préféré.

### DESCRIPTION DÉTAILLÉE D'UN MODE DE REALISATION

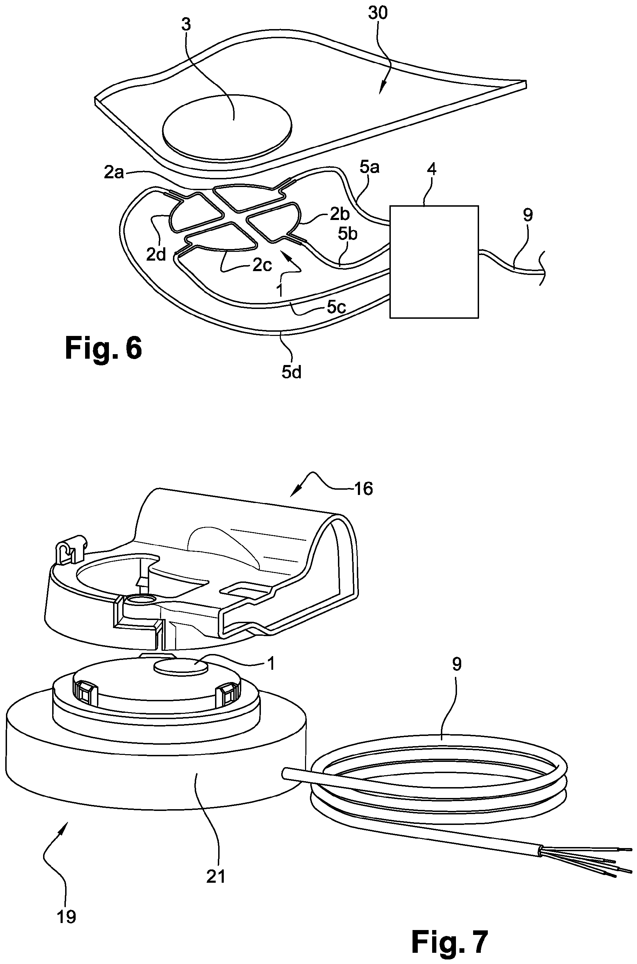

Selon un mode de réalisation non limitatif du dispositif de simulation du mouvement d'une portion d'une première surface (1) par rapport à une deuxième (30), la première surface (1) du dit dispositif est sensiblement plane et présente un contour fermé comprenant quatre bobines (2a, 2b, 2c, 2d), fixes par rapport à un premier capteur (3) (FIG. 6).

Chacune des quatre bobines (2a, 2b, 2c, 2d) est plate et est reliée électriquement à une première sortie d'une électronique de contrôle (4) au moyen de fils électrique (5a, 5b, 5c, 5d) (FIG. 6).

Chacune des quatre bobines (2a, 2b, 2c, 2d) présente une forme identique sensiblement en quart de disque (FIG. 6).

La première surface (1) formée par les quatre bobines (2a, 2b, 2c, 2d) présente sensiblement une forme de disque (FIG. 6).

Avantageusement, le dispositif de simulation peut comprendre plus de quatre bobines pour une meilleure résolution, ainsi les bobines étant plus nombreuses, elles simulent une portion plus petite par exemple d'un disque.

Le premier capteur (3) est sensible à l'induction électromagnétique et est disposé en regard des bobines (2a, 2b, 2c, 2d) (FIG. 6).

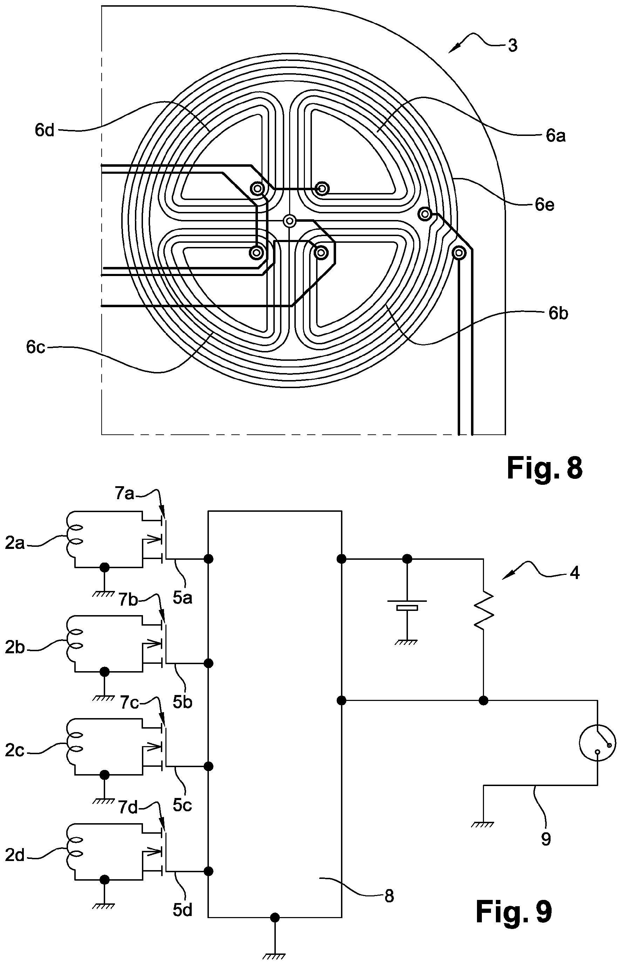

Le premier capteur (3) est composé de cinq bobines (6a, 6b, 6c, 6d, 6e) plates, dont quatre (6a, 6b, 6c, 6d) ont la même forme de quart de disque que les quatre bobines (2a, 2b, 2c, 2d) précédentes et sont disposées de la même manière pour former sensiblement un disque. La cinquième bobine (6e) présente une forme sensiblement en bande circulaire s'étendant le long du contour du disque formé par les quatre bobines (6a, 6b, 6c, 6d) du premier capteur (3). La cinquième bobine (6e) permet de générer l'excitation électromagnétique dans laquelle baigneront les bobines de la première surface (1) ainsi que celles du premier capteur (3) (FIG. 8).

L'électronique de contrôle (4) comprend quatre interrupteurs (7a, 7b, 7c, 7d). Chaque interrupteur (7a, 7b, 7c, 7d) est connecté à l'une des quatre bobines (2a, 2b, 2c, 2d) (FIG. 9).

L'électronique de contrôle (4) comprend un microprocesseur (8) programmable apte à commander les interrupteurs (7a, 7b, 7c, 7d) (FIG. 9).

Le premier capteur (3) est inclus dans la structure d'un module radio compact (16) (FIG. 7).

Le module radio compact (16) comprend un microprocesseur.

Les quatre bobines (2a, 2b, 2c, 2d) et l'électronique de contrôle (4) sont intégrées dans un même module interface (19) comprenant un carter de protection (21) respectant une modularité (FIG. 7).

Le module radio compact (16) respecte une modularité complémentaire à la modularité du module interface (19), de telle manière que le module radio compact (16) est clipsable sur le module interface (19) (FIG. 8).

Le fil électrique (9) permet de relier le module interface (19) à un compteur d'eau ou de gaz ou d'électricité, cette liste est non exhaustive.

## Revendications

1. Dispositif de simulation de mouvement comprenant un capteur de rotation (3) et une surface (1) disposée en vis-à-vis du capteur de rotation (3), la surface (1) comprenant des moyens de simulation d'un mouvement comprenant au moins deux bobines (2a, 2b, 2c, 2d) fixes par rapport au capteur (3), et
**dispositif caractérisé en ce que** :
- **le capteur de rotation (3) est composé de bobines plates (6a, 6b, 6c, 6d, 6e) et comprend une bobine (6e) d'excitation électromagnétique,**
- chaque bobine **(2a, 2b, 2c, 2d) de la surface (1)** est reliée à une première sortie d'une électronique de contrôle (4),
- **l'impédance d'**au moins une bobine **(2a, 2b, 2c, 2d) de la surface (1)** varie sensiblement différemment **de l'impédance** de l'autre ou des autres bobine(s),
- l'électronique de contrôle (4) comprend des moyens de contrôle de l'impédance des bobines (2a, 2b, 2c, 2d) **sous la forme de moyens de mise en court-circuit.**

2. Dispositif selon la revendication 1 **caractérisé en ce qu'**une entrée de l'électronique de contrôle (4) est connectée à une deuxième sortie émettant un signal électrique.

3. Dispositif selon l'une quelconque des revendications précédentes **caractérisé en ce que** l'ensemble comprenant les bobines (2a, 2b, 2c, 2d) et l'électronique de contrôle (4) est intégré dans un module interface (19).

4. Dispositif selon l'une quelconque des revendications précédentes **caractérisé en ce que** les bobines (2a, 2b, 2c, 2d) sont sensiblement plates.

5. Dispositif selon l'une quelconque des revendications précédentes **caractérisé en ce que** chaque bobine forme un secteur de disque.

6. Ensemble comprenant le dispositif selon une des revendications précédentes et le capteur de rotation (3), **caractérisé en ce qu'**il est sensible à l'induction électromagnétique et est disposé en regard des bobines (2a, 2b, 2c, 2d).

7. Ensemble selon la revendication précédente **caractérisé en ce que** le capteur (3) et le dispositif de simulation de mouvement communiquent entre eux par une communication numérique.

8. Ensemble selon l'une quelconque des revendications 6 ou 7 **caractérisé en ce que** le capteur (3) est relié à un dispositif de traitement et d'interprétation des informations transmises par le capteur (3).

## Patentansprüche

1. Vorrichtung zur Simulation einer Bewegung, umfassend einen Rotationssensor (3) und eine Fläche (1), die gegenüberliegend von dem Rotationssensor (3) angeordnet ist, wobei die Fläche (1) Mittel zur Simulation einer Bewegung aufweist, die mindestens zwei Spulen (2a, 2b, 2c, 2d), die gegenüber dem Sensor (3) fest sind, aufweisen,
Vorrichtung, die **dadurch gekennzeichnet ist, dass**:
- der Rotationssensor (3) aus flachen Spulen (6a, 6b, 6c, 6d, 6e) besteht und eine elektromagnetische Erregerspule (6e) aufweist,
- jede Spule (2a, 2b, 2c, 2d) der Fläche (1) mit einem ersten Ausgang einer Steuerelektronik (4) verbunden ist,
- die Impedanz von mindestens einer Spule (2a, 2b, 2c, 2d) der Fläche (1) im Wesentlichen unterschiedlich von der Impedanz der anderen Spule oder der anderen Spulen variiert,
- die Steuerelektronik (4) Mittel zur Kontrolle der Impedanz der Spulen (2a, 2b, 2c, 2d) in Form von Mitteln zum Kurzschließen aufweist.

2. Vorrichtung nach Anspruch 1, **dadurch gekennzeichnet, dass** ein Eingang der Steuerelektronik (4) mit einem zweiten Ausgang verbunden ist, der ein elektrisches Signal sendet.

3. Vorrichtung nach einem der vorhergehenden Ansprüche, **dadurch gekennzeichnet, dass** die Anordnung, die die Spulen (2a, 2b, 2c, 2d) und die Steuerelektronik (4) aufweist, in einem Schnittstellenmodul (19) integriert ist.

4. Vorrichtung nach einem der vorhergehenden Ansprüche, **dadurch gekennzeichnet, dass** die Spulen (2a, 2b, 2c, 2d) im Wesentlichen flach sind.

5. Vorrichtung nach einem der vorhergehenden Ansprüche, **dadurch gekennzeichnet, dass** jede Spule einen Scheibensektor bildet.

6. Anordnung, umfassend die Vorrichtung nach einem der vorhergehenden Ansprüche und den Rotationssensor (3), **dadurch gekennzeichnet, dass** sie gegenüber elektromagnetischer Induktion empfindlich ist und gegenüberliegend zu den Spulen (2a, 2b, 2c, 2d) angeordnet ist.

7. Anordnung nach dem vorhergehenden Anspruch, **dadurch gekennzeichnet, dass** der Sensor (3) und die Vorrichtung zur Simulation einer Bewegung durch eine digitale Kommunikation miteinander kommunizieren.

8. Anordnung nach einem der Ansprüche 6 oder 7, **dadurch gekennzeichnet, dass** der Sensor (3) mit einer Vorrichtung zum Verarbeiten und Interpretieren der Informationen, die von dem Sensor (3) übertragen werden, verbunden ist.

## Claims

1. Device for simulating movement comprising a rotation sensor (3) and a surface (1) arranged facing the rotation sensor (3), the surface (1) comprising means for simulating a movement comprising at least two coils (2a, 2b, 2c, 2d) that are fixed relative to the sensor (3),
device **characterized in that**:
- the rotation sensor (3) is composed of flat coils (6a, 6b, 6c, 6d, 6e) and comprises an electromagnetic excitation coil (6e),
- each coil (2a, 2b, 2c, 2d) of the surface (1) is linked to a first output of a control electronic circuit (4),
- the impedance of at least one coil (2a, 2b, 2c, 2d) of the surface (1) varies substantially differently from the impedance of the other coil or coils,
- the control electronics (4) comprises means for controlling the impedance of the coils (2a, 2b, 2c, 2d) in the form of short circuit means.

2. Device according to Claim 1, **characterized in that** an input of the control electronics (4) is connected to a second output emitting an electrical signal.

3. Device according to either one of the preceding claims, **characterized in that** the assembly comprising the coils (2a, 2b, 2c, 2d) and the control electronics (4) is incorporated in an interface module (19).

4. Device according to any one of the preceding claims, **characterized in that** the coils (2a, 2b, 2c, 2d) are substantially flat.

5. Device according to any one of the preceding claims, **characterized in that** each coil forms a disc segment.

6. Assembly comprising the device according to one of the preceding claims and the rotation sensor (3), **characterized in that** it is sensitive to electromagnetic induction and is arranged facing the coils (2a, 2b, 2c, 2d).

7. Assembly according to the preceding claim, **characterized in that** the sensor (3) and the movement simulation device communicate with one another by a digital communication.

8. Assembly according to either one of Claims 6 and 7, **characterized in that** the sensor (3) is linked to a device for processing and interpreting information transmitted by the sensor (3).
